(19) Europäisches Patentamt
European Patent Office
Office européen des brevets

(11) **EP 4 530 945 A1**

(12) **EUROPEAN PATENT APPLICATION**

(43) Date of publication:
**02.04.2025 Bulletin 2025/14**

(21) Application number: **24195842.0**

(22) Date of filing: **22.08.2024**

(51) International Patent Classification (IPC):
**G06Q 10/04** (2023.01)　　　**G06Q 50/26** (2024.01)

(52) Cooperative Patent Classification (CPC):
**G06Q 10/04; G06Q 50/265;** G06V 20/53

| | |
|---|---|
| (84) Designated Contracting States:<br>**AL AT BE BG CH CY CZ DE DK EE ES FI FR GB GR HR HU IE IS IT LI LT LU LV MC ME MK MT NL NO PL PT RO RS SE SI SK SM TR**<br>Designated Extension States:<br>**BA**<br>Designated Validation States:<br>**GE KH MA MD TN**<br><br>(30) Priority: **28.09.2023 JP 2023168801**<br><br>(71) Applicant: **Fujitsu Limited**<br>**Kawasaki-shi, Kanagawa 211-8588 (JP)** | (72) Inventors:<br>• **Makinoshima, Fumiyasu**<br>**Kawasaki-shi, Kanagawa 211-8588 (JP)**<br>• **Takahashi, Tetsuro**<br>**Kawasaki-shi, Kanagawa 211-8588 (JP)**<br><br>(74) Representative: **Hoffmann Eitle**<br>**Patent- und Rechtsanwälte PartmbB**<br>**Arabellastraße 30**<br>**81925 München (DE)** |

(54) **PREDICTION PROGRAM, PREDICTION METHOD, AND INFORMATION PROCESSING APPARATUS FOR MEASURING A FEATURE AMOUNT RELATED TO A PLURALITY OF OPTIONS AND A PEOPLE FLOW**

(57)　A prediction program causing a computer to execute a process includes measuring a feature amount related to a plurality of options and a people flow to be reproduced based on the plurality of options, executing a simulation of the people flow by using the measured feature amount, specifying a model that determines a behavior of the people flow in accordance with an input of the measured feature amount, based on the executed simulation of the people flow and the measured people flow; and predicting the people flow based on the specified model.

FIG. 1

**Description**

FIELD

The embodiments discussed herein are related to a prediction program, a prediction method, and an information processing apparatus.

BACKGROUND

Congestion may occur in a situation where a flow of people is concentrated, such as when an event is held or when evacuation is performed when a disaster occurs, and an accident due to the congestion or human damage due to a delay in evacuation may occur. Therefore, when it is possible to predict a congestion situation that may occur in advance and examine and intervene in measures such as evacuation guidance before an event occurs, it leads to avoidance of occurrence of an accident or human damage and reduction in risk. Accordingly, it is important to predict the people flow in future.

For the prediction of the people flow, an agent-based simulation in which motions of individual persons are modeled is used. Agent-based simulation simulates movement and interference by assuming a behavior of each pedestrian, and predicts a people flow. Meanwhile, since the agent-based simulation is a so-called What-if scenario analysis and it is not known whether a situation of the simulation actually occurs, there is an aspect in which the situation is not actually predicted.

From such an aspect, it has been studied to apply a method of improving prediction accuracy of a simulation (may be referred to as "data assimilation") by incorporating observation data into the simulation such as weather prediction to the prediction of the people flow.

As an example of a technique of applying the data assimilation to the prediction of the people flow, the following related art is proposed. For example, in the related art, it is assumed that a state of a people flow is a superposition of behaviors based on a plurality of behavior intentions. Under such an assumption, in the related art, the state of the people flow reproduced by a combination of different behavior modes is predicted, and in a case where observation data is obtained, a prediction result is evaluated from a degree of coincidence with the observation data, and a behavior intention of a crowd is estimated and updated based on the prediction result. Thus, a result of simulation with higher accuracy is obtained as a superposition of plausible simulation sets.

Citation List

Patent Literature

Japanese Laid-open Patent Publication No. 2023-90405 is disclosed as related art.

SUMMARY OF INVENTION

TECHNICAL PROBLEM

Meanwhile, in the related art described above, there is an aspect in which, when a tendency of the behavior of the crowd is changed after the simulation is matched with the observation data by the data assimilation, it is difficult to cause the simulation to follow the actual behavior up to a lead time desired to execute an intervention.

In one aspect, an object of the present disclosure is to provide a prediction program, a prediction method, and an information processing apparatus capable of following a simulation up to a lead time desired to execute an intervention.

SOLUTION TO PROBLEM

According to an aspect of the embodiments, a prediction program causing a computer to execute a process includes measuring a feature amount related to a plurality of options and a people flow to be reproduced based on the plurality of options, executing a simulation of the people flow by using the measured feature amount, specifying a model that determines a behavior of the people flow in accordance with an input of the measured feature amount, based on the executed simulation of the people flow and the measured people flow; and predicting the people flow based on the specified model.

EFFECTS OF INVENTION

A simulation may be followed up to a lead time desired to execute an intervention.

BRIEF DESCRIPTION OF DRAWINGS

FIG. 1 is a diagram illustrating a configuration example of a prediction system;
FIG. 2 is a diagram illustrating an aspect of a problem;
FIG. 3 is a diagram illustrating a problem solving approach in the related art;
FIG. 4 is a diagram illustrating a problem solving approach according to Embodiment 1;
FIG. 5 is a block diagram illustrating a functional configuration example of a server apparatus;
FIG. 6 is a diagram illustrating a people flow to be reproduced and predicted;
FIG. 7 is a diagram illustrating an example of observation data;
FIG. 8 is a diagram illustrating an example of a feature amount;
FIG. 9 is a schematic diagram illustrating an example of data assimilation;

FIG. 10 is a diagram illustrating an example of a temporal change in the total number of persons;

FIG. 11 is a diagram illustrating an example of a prediction result in the related art;

FIG. 12 is a diagram illustrating an example of a prediction result according to Embodiment 1;

FIG. 13 is a diagram illustrating an aspect of a prediction error;

FIG. 14 is a flowchart illustrating a procedure of a data assimilation process;

FIG. 15 is a schematic diagram illustrating an application example of the data assimilation; and

FIG. 16 is a diagram illustrating a hardware configuration example.

DESCRIPTION OF EMBODIMENTS

Hereinafter, embodiments of a prediction program, a prediction method, and an information processing apparatus, which are disclosed herein, will be described with reference to the accompanying drawings. Each of the embodiments is merely an example, and a configuration or a structure, a function, a numerical value used for specifying these, a use scene, and the like are not limited by such an example. In each of the embodiments, it is possible to combine the embodiments appropriately as long as processing contents are not contradicted.

<Embodiment 1>

<System Configuration>

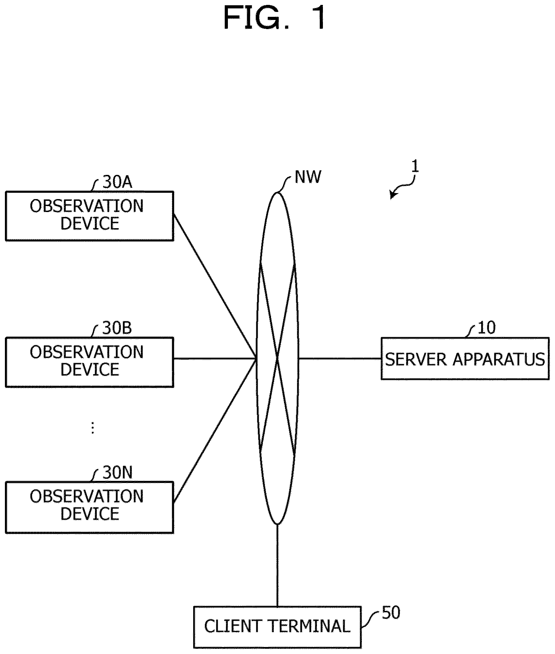

FIG. 1 is a diagram illustrating a configuration example of a prediction system. A prediction system 1 illustrated in FIG. 1 provides a prediction function of estimating a behavior model that reproduces observation data related to a people flow by data assimilation in which the observation data is incorporated into a simulation, and predicting the people flow based on the estimated behavior model. For example, the prediction system 1 constructs a digital twin that predicts a people flow.

As illustrated in FIG. 1, the prediction system 1 may include a server apparatus 10, observation devices 30A to 30N, and a client terminal 50. Hereinafter, in a case where the individual observation devices 30A to 30N do not have to be distinguished from each other, the observation devices 30A to 30N may be referred to as an "observation device 30".

The server apparatus 10, the observation device 30, and the client terminal 50 may be communicably coupled to each other via arbitrary network NW. For example, the network NW may be realized by arbitrary technique such as a power-saving wireless communication standard for an intranet, the Internet, or the Internet of Things (IoT), regardless of whether the technique is wired or wireless. The network NW is not limited to a single network, and an intranet and the Internet may be coupled via a network device such as a gateway.

The server apparatus 10 is an example of an information processing apparatus that provides the prediction function described above. For example, the server apparatus 10 may be realized as a platform as a service (PaaS) type application or a software as a service (SaaS) type application, thereby providing a prediction service corresponding to the prediction function described above as a cloud service. Alternatively, the server apparatus 10 may be realized as a server that provides the prediction function described above on-premises.

The observation device 30 is an apparatus for observing a people flow in a predetermined area. For example, the observation device 30 may be realized by a camera device. As an example of observation data, an image captured by the observation device 30 or a people flow density map (person/m²) generated from the image is obtained. Alternatively, the observation device 30 may be realized by a GPS receiver or the like. In this case, position information of the people flow is obtained as an example of the observation data.

The client terminal 50 is a terminal device used by a client, which is provided with the prediction function described above. For example, the client terminal 50 may be realized by arbitrary computer such as a personal computer, a smartphone, a tablet terminal, and a wearable terminal.

Although FIG. 1 illustrates the example in which a plurality of observation devices 30 are included in the prediction system 1, the prediction system 1 may include one observation device 30. Although FIG. 1 illustrates the example in which one client terminal 50 is coupled to the server apparatus 10, a plurality of client terminals 50 may be coupled to the server apparatus 10.

<One Aspect of Problem>

As described in the background section, in the related art described above, there is an aspect in which, when the tendency of the behavior of the crowd is changed after the simulation is matched with the observation data by the data assimilation, it is difficult to cause the simulation to follow the actual situation up to the lead time desired to perform the intervention.

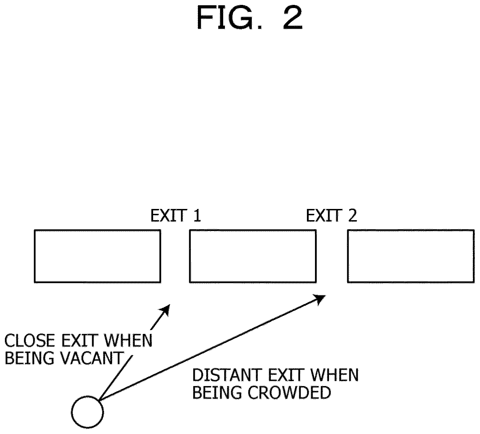

FIG. 2 is a diagram illustrating an aspect of the problem. FIG. 2 illustrates an example in which an agent-based simulation is applied to an exit selection problem in which a crowd entering from a lower left of FIG. 2 selects an exit 1 or an exit 2, as an example of a use case.

In this case, in the related art described above, attention is paid to the fact that it is often sufficient to predict a macro phenomenon such as congestion at an exit instead of estimating a position of each pedestrian, and observed behaviors are assimilated on the assumption that some simple behavior intentions (modes) are superimposed. For example, in the example illustrated in FIG. 2, data assimilation is executed on the assumption that a behavior intention $\Theta1$ toward the exit 1 and a behavior intention $\Theta2$ toward the exit 2 are superimposed on each other.

According to such a related art, in a case where a tendency of the behavior is not changed, prediction accuracy after estimation is high. On the other hand, in a case where the apparent behavior is changed, when the behavior is changed after the simulation is matched with the observation data, it is difficult to cause the simulation to follow the actual behavior.

This is because the tendency of the behavior is not necessarily fixed in the exit selection problem illustrated in FIG. 2. For example, a selection ratio of the exit 1 and the exit 2 differs between when the exit is vacant and when the exit is crowded. For example, when the exit 1 close to an entrance position is vacant, the exit 1 is selected, and when the exit 1 close to the entrance position is crowded, the exit 2 is selected.

In this manner, in the related art described above, it is difficult to predict a situation when the exit 1 is crowded or a situation when the exit 1 is vacant based on the observation data when the exit 1 is vacant and the observation data when the exit 1 is crowded.

<One Aspect of Problem Solving Approach>

From an aspect of solving such a problem, with the prediction function according to the present embodiment, a behavior model that reproduces observation data by data assimilation is estimated, and a people flow is predicted based on a simulation including the estimated behavior model.

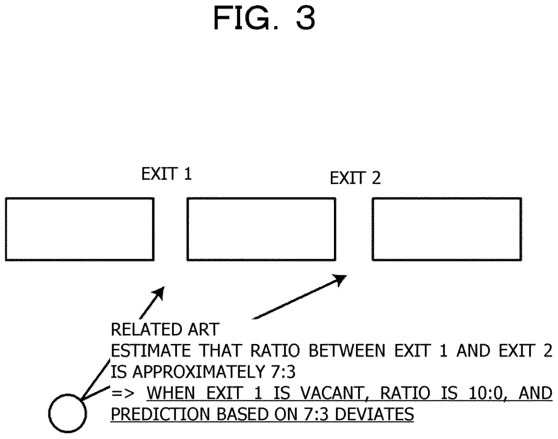

FIG. 3 is a diagram illustrating a problem solving approach in the related art. As illustrated in FIG. 3, in the related art described above, the superposition of the behavior modes of the behavior intention $\Theta1$ toward the exit 1 and the behavior intention $\Theta2$ toward the exit 2 by the data assimilation is estimated to be 7:3.

In this manner, in the data assimilation according to the related art described above, the prediction is limited to a prediction based on the assumption that "since this is a case at present, such a tendency will continue in future". Therefore, when the exit 1 is vacant, a selection ratio between the exit 1 and the exit 2 is 10:0, so that the prediction based on the superposition "7:3" of the behavior modes of the behavior intention $\Theta1$ and the behavior intention $\Theta2$ deviates.

On the other hand, according to the present embodiment, the data assimilation is developed to estimate the behavior model itself that "in such a situation, such a determination is made".

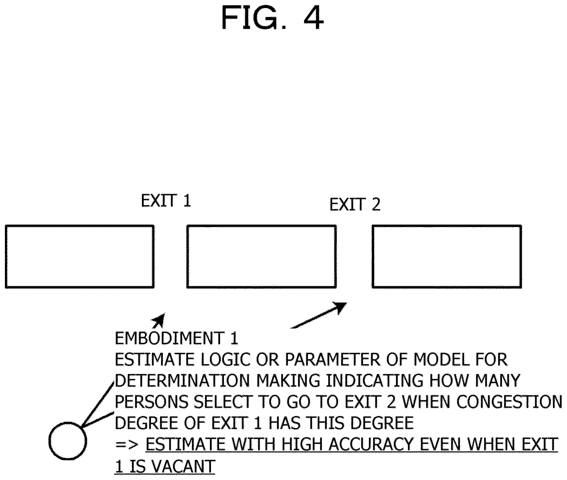

FIG. 4 is a diagram illustrating a problem solving approach according to Embodiment 1. As illustrated in FIG. 4, in the present embodiment, when a congestion degree of the exit 1 has this degree, data assimilation is executed to estimate a logic or a parameter of a model for determination making indicating how many persons select to go to the exit 2. Therefore, since a people flow may be predicted with high accuracy even when the exit 1 is vacant, even when the tendency of the behavior of the crowd is changed after the simulation is matched with the observation data by the data assimilation, it is possible to cause the simulation to follow the actual behavior.

Therefore, with the prediction function according to the present embodiment, it is possible to follow the simulation up to a lead time desired to execute an intervention.

As a problem solving approach, an entrance selection problem may be targeted instead of an exit selection problem. The agent-based simulation may be applied to the entrance selection problem in which a crowd selects an entrance 1 or an entrance 2.

<Configuration of Server Apparatus 10>

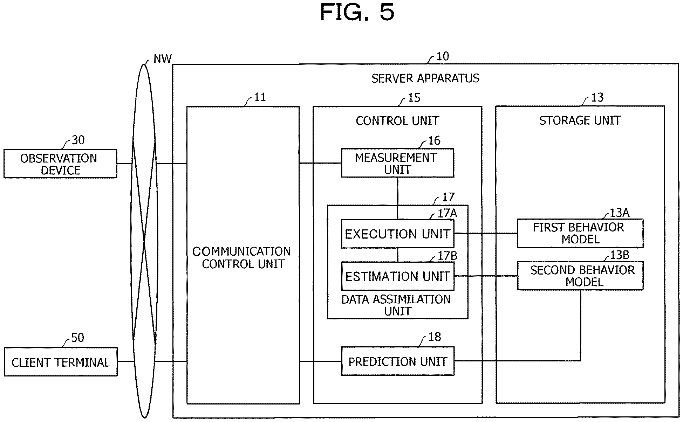

Next, a functional configuration example of the server apparatus 10 according to the present embodiment will be described. FIG. 5 is a block diagram illustrating a functional configuration example of the server apparatus 10. FIG. 5 schematically illustrates a block related to a prediction function of the server apparatus 10.

As illustrated in FIG. 5, the server apparatus 10 includes a communication control unit 11, a storage unit 13, and a control unit 15. FIG. 5 merely illustrates an extraction of functional units related to the prediction function described above, and a functional unit other than the illustrated functional units may be included in the server apparatus 10.

The communication control unit 11 is a functional unit that controls communication with another apparatus such as the observation device 30 or the client terminal 50. As an example, the communication control unit 11 may be realized by a network interface card. As one aspect, the communication control unit 11 may receive observation data from the observation device 30, and may output an instruction to upload the observation data or a setting to the observation device 30. As another aspect, the communication control unit 11 may receive a request for requesting a prediction result of a simulation from the client terminal 50, and may output the prediction result of the simulation to the client terminal 50.

The storage unit 13 is a functional unit that stores various types of data. As an example only, the storage unit 13 is realized by an internal, external, or auxiliary storage of the server apparatus 10. For example, the storage unit 13 stores a first behavior model 13A and a second behavior model 13B. Description of the first behavior model 13A and the second behavior model 13B will be described together in a case where reference, generation, or registration is executed.

The control unit 15 is a functional unit that performs overall control of the server apparatus 10. For example, the control unit 15 may be realized by a hardware processor. As illustrated in FIG. 5, the control unit 15 includes a measurement unit 16, a data assimilation unit 17, and a prediction unit 18. The control unit 15 may be realized by a hard wired logic or the like.

The measurement unit 16 is a processing unit that measures a feature amount related to a plurality of options and a people flow to be reproduced based on the plurality of options. According to one aspect, the measurement unit 16 acquires observation data uploaded from the observation device 30. As an example of such observation data, the measurement unit 16 acquires an image captured by the observation device 30 or a density map of a people flow generated from the image. The density map may be generated by the observation device 30, or may be generated by the measurement unit 16 from the image captured by the observation device 30. For example, the measurement unit 16 generates observation data related to the people flow by analyzing an image of an area in which a structure (doorway) corresponding to the plurality of options is disposed, the image being captured by a camera device. As another aspect, the measurement unit 16 measures, from the observation data, a feature amount corresponding to an option for a behavior determined by an agent in a virtual space to be reproduced. For example, the plurality of options are gates indicating any of an entrance for a person to enter a predetermined location or an exit for a person to exit from the predetermined location. The feature amount is, for example, a distance to a gate or a congestion degree of the gate.

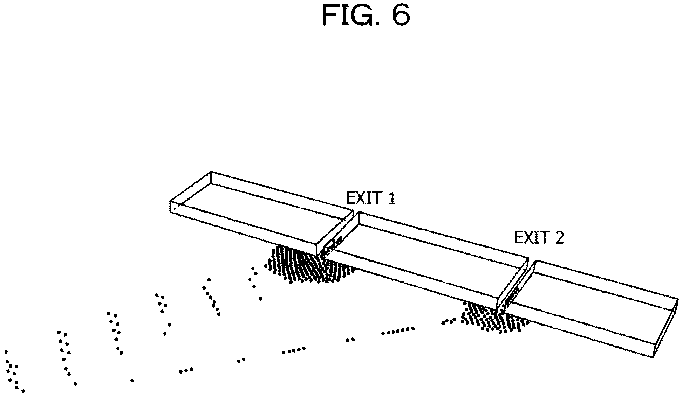

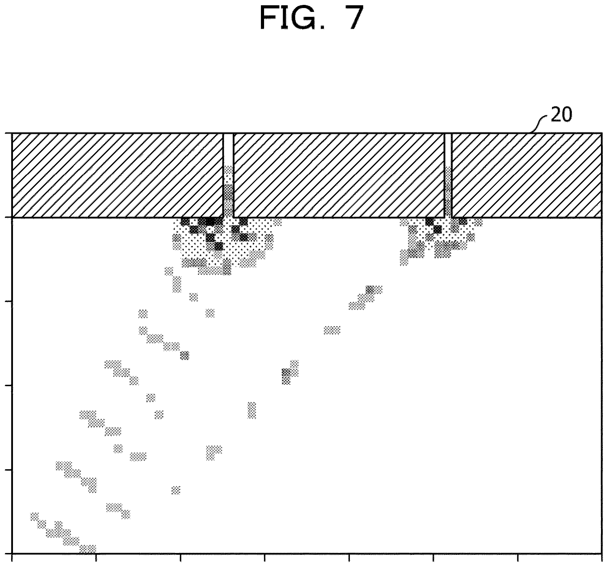

FIG. 6 is a diagram illustrating a people flow to be reproduced and predicted. FIG. 6 illustrates an example in which an agent-based simulation is applied to an exit selection problem in which a crowd entering from a lower left of FIG. 6 selects the exit 1 or the exit 2, as an example of a use case. As an example of such a use case, the measurement unit 16 may acquire a density map 20 illustrated in FIG. 7 from the observation device 30 at an arbitrary cycle, for example, a cycle of 5 seconds.

FIG. 7 is a diagram illustrating an example of observation data. FIG. 7 illustrates the density map 20 as the example of the observation data. As illustrated in FIG. 7, a population density per certain area is mapped in the density map 20. For example, a population density (person/m$^2$) may be calculated by performing meshing on an image captured by the observation device 30 and dividing, for each grid cell included in the mesh, the number of persons observed in the grid cell by the area of the grid cell.

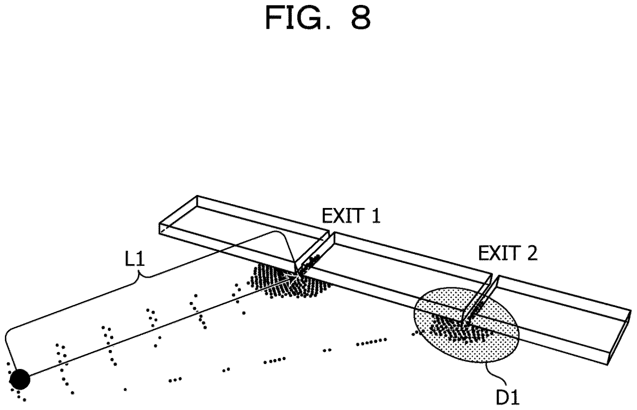

FIG. 8 is a diagram illustrating an example of a feature amount. FIG. 8 illustrates an example of options of the exit 1 and the exit 2 corresponding to a destination point or a route, as an example of an option for a behavior of an agent. In this case, as one feature amount, a distance to the exit may be measured. For example, as illustrated in FIG. 8, a distance L1 from a position of each agent to the exit 1 may be calculated. Although the distance L1 to the exit 1 is illustrated in FIG. 8, it goes without saying that a distance L2 from the position of each agent to the exit 2 may be measured in the same manner. As another feature amount, a congestion degree at each exit may be measured. For example, as illustrated in FIG. 8, a congestion degree D1 at the exit 2 may be calculated. Although the congestion degree D1 at the exit 2 is illustrated in FIG. 8, it goes without saying that a congestion degree D2 at the exit 1 may also be measured in the same manner.

The data assimilation unit 17 is a processing unit that executes data assimilation in which observation data related to a people flow is incorporated into a simulation. As an example of a simulation used for such a people flow prediction, an agent-based simulation is used. Hereinafter, the agent-based simulation may be referred to as an "ABS".

By way of example only, the data assimilation unit 17 compares a result of a simulation of a people flow with a people flow obtained as observation data to estimate a behavior model that reproduces the observation data among behavior models for determining a behavior of an agent.

As an example, an example in which a particle filter is used for estimation of a behavior model by data assimilation will be described below. As illustrated in FIG. 5, the data assimilation unit 17 includes an execution unit 17A and an estimation unit 17B.

The execution unit 17A is a processing unit that executes a simulation of a people flow. For example, in the example of the ABS model, the simulation is continued by incrementing a time step $\Delta t$, for example, one second at a time from an initial value of a time t of the ABS. At this time, when the initial value of the time t is set, a virtual space corresponding to an environment of the exit selection problem illustrated in FIG. 6 is modeled via geographical information system (GIS) software or the like. An agent having position information of two dimensional coordinates or three dimensional coordinates is mapped to such a virtual space.

For example, the execution unit 17A generates a simulation group by executing a plurality of ABS models in parallel at a start of data assimilation. A different behavior model is incorporated into each particle included in such a simulation group. For example, the execution unit 17A assigns a different parameter set to the first behavior model 13A stored in the storage unit 13 for each particle, and incorporates the different parameter set into the ABS model. Needless to say, the execution unit 17A may generate arbitrary number N (natural number) of particles.

As an example of such a first behavior model 13A, a discrete selection model will be described as an example. The discrete selection model is defined by a utility function $U_i$ including a definite term $V_i$ and an error term $\varepsilon_i$. Here, "i" indicates an index of an option. For example, the definite term $V_i$ may be represented by a linear sum of an explanatory variable $x_i$. For example, when an option for the exit 1 is i = 1, an option for the exit 2 is i = 2, a congestion degree of the exit 1 is $x_1$, and a congestion degree of the exit 2 is $x_2$, the definite term $V_i$ may be defined by the following Equation (1) and the following Equation (2), as an example. Here, although an example in which the congestion degree is included is described as an example of the explanatory variable, the distance to each exit may be further included.

$$V_1 = \theta_1 + \theta_2 x_1 \cdots (1)$$

$$V_2 = 0 + \theta_2 x_2 \cdots (2)$$

For example, the execution unit 17A changes, for each of N particles, a parameter set including the parameter $\theta_1$ and the parameter $\theta_2$ of a discrete selection model incorporated into a simulation corresponding to the particle. By way of example only, the execution unit 17A sets an initial value of the parameter $\theta_1$ in accordance with the uniform random number U (-5, 5), and sets an initial value of the parameter $\theta_2$ in accordance with the uniform random number U (-5, 0).

In this manner, in the present embodiment, even in a case of the same discrete selection model, the discrete selection model to which a different parameter set is assigned is identified as a different behavior model.

The execution unit 17A executes the simulation at the time t for each particle to generate a simulation result. For example, the execution unit 17A updates a state of an agent, for example, a position, a speed, or the like, based on a behavior output by the behavior model to which a feature amount measured by the measurement unit 16, for example, a congestion degree of each exit, or the like is input, for example, a selection result of an exit for each agent. Thus, the simulation result at the time t is obtained.

The estimation unit 17B is a processing unit that estimates a behavior model that reproduces observation data in a behavior model group corresponding to a simulation group. "Estimation" described in the present embodiment may be replaced with "specification". For example, the "estimation unit 17B" may be replaced with a "specification unit 17B".

For example, the estimation unit 17B may start a process in a case where new observation data is acquired. For example, the estimation unit 17B compares the simulation result executed for each particle by the execution unit 17A with the observation data, and calculates a matching degree between the simulation result corresponding to each particle and the observation data.

At this time, in a case where formats are different between the simulation result and the observation data, the simulation result is converted into the same format as the format of the observation data. For example, in the ABS model, position information of each agent is obtained at each time t, and the density map 20 illustrated in FIG. 7 is acquired as the observation data. In this case, the simulation result is converted into a density map. By way of example only, such conversion may be realized by counting, for each grid cell of the density map, the number of agents having position information included in a range of the grid cell.

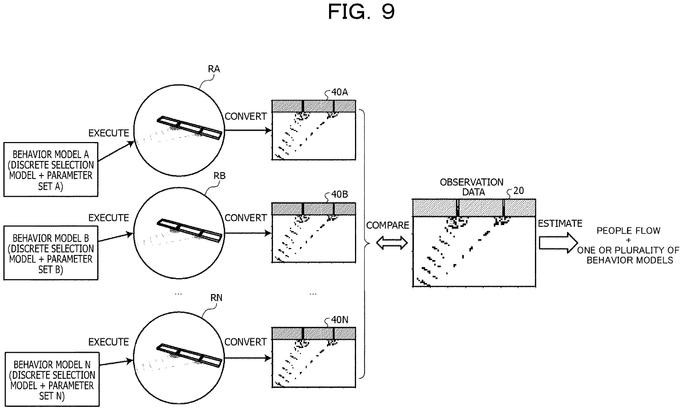

FIG. 9 is a schematic diagram illustrating an example of data assimilation. FIG. 9 illustrates simulation results RA to RN corresponding to N particles, respectively. As illustrated in FIG. 9, the simulation results RA to RN are execution results of a simulation into which behavior models A to N obtained by assigning different parameter sets A to N to the parameters $\theta_1$ and $\theta_2$ of a discrete selection model are incorporated.

These simulation results RA to RN are respectively converted into density map 40A to 40N, from the aspect of matching with a format of the observation data 20. A matching degree is calculated between the density maps 40A to 40N corresponding to the respective particles and the density map 20 corresponding to observation data.

As an example, such a matching degree may be a reciprocal number or the like of an error between the two density maps. For example, the estimation unit 17B calculates the total amount of errors between the two density maps by totaling a difference in population density of each grid cell between the two density maps as an error. The estimation unit 17B calculates a likelihood by using the reciprocal number of the total amount of errors between the two density maps. The likelihood obtained in this manner may be used as a matching degree.

Based on the matching degree between the simulation results RA to RN and the observation data 20, the estimation unit 17B evaluates the simulation results RA to RN. For example, as the error between the simulation result 40 and the observation data 20 is decreased, the matching degree (likelihood) is increased, and as the error between the simulation result 40 and the observation data 20 is increased, the matching degree (likelihood) is decreased. Therefore, it is possible to evaluate that a particle having a higher matching degree (likelihood) has a higher degree of reproduction of observation data.

By way of example only, the estimation unit 17B estimates a behavior model that reproduces the observation data 20 among behavior models of N particles corresponding to the simulation results RA to RN. For example, the estimation unit 17B may estimate a behavior model of a particle corresponding to a simulation result having the highest matching degree with the observation data 20, and the simulation result. Alternatively, the estimation unit 17B may estimate a behavior model of a particle group corresponding to a simulation result having a matching degree with respect to the observation data 20, which is equal to or higher than a threshold value Th1 and a superposition of the simulation results of the particle group. The estimation unit 17B may estimate a behavior model of a particle group corresponding to a simulation result in which a matching degree with the observation data 20 corresponds to a top specific number, and a superposition of the simulation results of the particle group.

After the estimation of such a behavior model, the estimation unit 17B reconstructs a simulation group based on the results of evaluating the simulation results RA to RN. As one aspect, the estimation unit 17B replicates a simulation into which a behavior model obtained as an estimation result is incorporated. For example, as a matching degree with respect to the observation data 20 becomes higher, the number of replications of the simulation into which the behavior model of the estimation result is incorporated may be set to be larger. At this time, parameter sets of the behavior models do not have to be completely identical between the respective simulations, and a uniform random number may be set in a range in the vicinity of the parameter $\theta_1$ and the parameter $\theta_2$ included in the parameter set of the behavior model of the estimation result. As another aspect, the estimation unit 17B may delete a particle corresponding to a simulation result of which a matching degree with respect to the observation data 20 is less than a threshold value Th2.

After that, the estimation unit 17B outputs the reconstructed simulation group and a state of an agent, for example, a position or a speed to the execution unit 17A, and causes the execution unit 17A to execute the simulation at the time t + the time step $\Delta t$. At this time, the estimation unit 17B may output, as the state of the agent, a superposition of simulation results in which the matching degree with the observation data 20 satisfies a specific condition, or a correction result obtained by correcting the superposition of the simulation results based on the observation data.

The estimation result of the behavior model obtained by repeating such data assimilation over a predetermined period is stored in the storage unit 13 as the second behavior model 13B.

The prediction unit 18 is a processing unit that predicts a people flow based on the behavior model estimated by the estimation unit 17B. As an example, the prediction unit 18 executes a future prediction of the people flow by executing a simulation based on the second behavior model 13B stored in the storage unit 13.

For example, when data assimilation is executed over a specific period, the prediction unit 18 generates, for each behavior model estimated as the second behavior model 13B, in parallel, a simulation into which the behavior model is incorporated. At this time, as the state of the agent mapped to a virtual space in each simulation, a superposition of simulation results associated with the second behavior model 13B or a correction result obtained by correcting the superposition of the simulation results based on the latest observation data may be set as an initial value. The simulation group generated in this manner uses, as a current time point, a time point at which a specific period elapses after data assimilation is started, and executes a future prediction of a people flow for a period equal to or longer than a lead time desired to execute intervention from the current time point.

After that, the prediction unit 18 may output a result of the future prediction of the people flow to the client terminal 50. For example, the prediction unit 18 may output, for each time when the simulation group is executed, a superposition of simulation results at the time or a density map generated from the superposition of simulation results to the client terminal 50. Alternatively, in a case where a congestion degree of a specific area, for example, a peripheral portion of the exit 1 or a peripheral portion of the exit 2, which is calculated from a superposition of simulation results or a density map, is equal to or higher than a threshold value Th3, the prediction unit 18 may output an alert to the client terminal 50. Here, although the client terminal 50 is described as an example of an output destination, the output destination is not limited to this. For example, the result of the future prediction of the people flow may be output to another apparatus other than the client terminal 50, or may be output to a service or an application executed in a backend.

<Example of Numerical Value Experiment>

Next, prediction results of a people flow in the exit selection problem illustrated in FIG. 6 are compared between the related art and the present embodiment described above. As an example, it is assumed that a simulation is performed under the following condition in the related art and the present embodiment described above.

First, as a first point, it is assumed that a density map having a mesh of 10 m is obtained as observation data. As a second point, it is assumed that data assimilation is executed based on the observation data acquired at intervals of 5 seconds. As a third point, it is assumed that correct answer data is generated by setting the parameter $\theta_1$ and the parameter $\theta_2$ of a discrete selection model to 4.5 ± 0.45 ($\sigma$) - 2.5 ± 0.25 ($\sigma$).

Under such a condition, in the related art described above, data assimilation is executed to estimate the parameter $\Theta$ for determining a distribution of the behavior intention $\Theta 1$ toward the exit 1 and the behavior intention $\Theta 2$ toward the exit 2. On the other hand, according to the present embodiment, data assimilation for estimating the parameter $\theta_1$ and the parameter $\theta_2$ of the discrete selection model is executed.

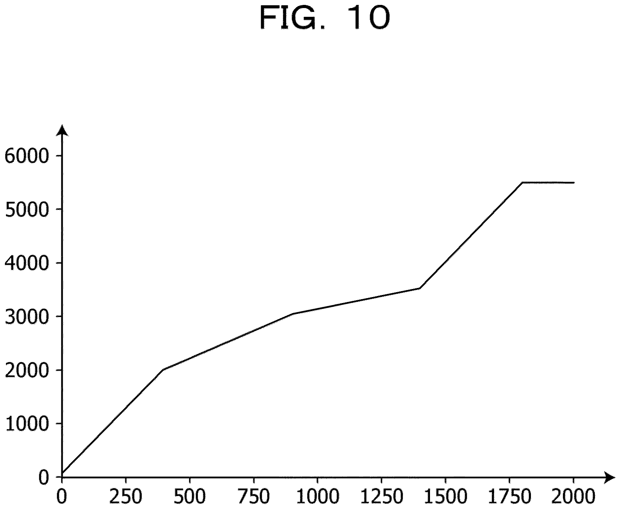

FIG. 10 is a diagram illustrating an example of a temporal change in the total number of persons. FIG. 10 illustrates the accumulated number of persons who enter an environment having the exit 1 and the exit 2 based on correct answer data in chronological order. A vertical axis of a graph illustrated in FIG. 10 indicates the total number of persons, and a horizontal axis indicates a time of a simulation. As illustrated in FIG. 10, according to the correct answer data, approximately 5500 persons in total enter the environment having the exit 1 and the exit 2. A slope in a section from 0 seconds to approximately 370 seconds of the simulation time and a slope in a section from approximately 1350 seconds to approximately 1750 seconds of the simulation time are larger than slopes in the other sections. These sections correspond to the first wave congestion and the second wave congestion in which the number of pedestrians are increased due to an event such as boarding and alighting of a train.

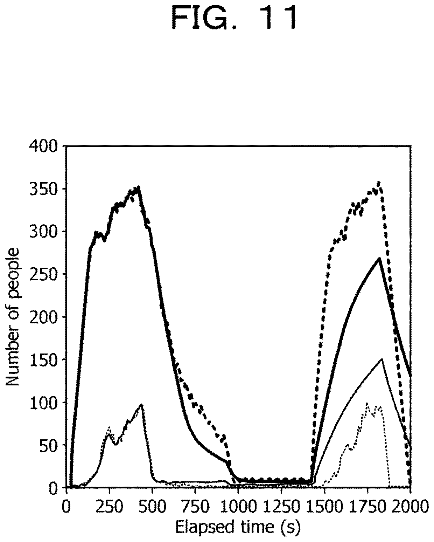

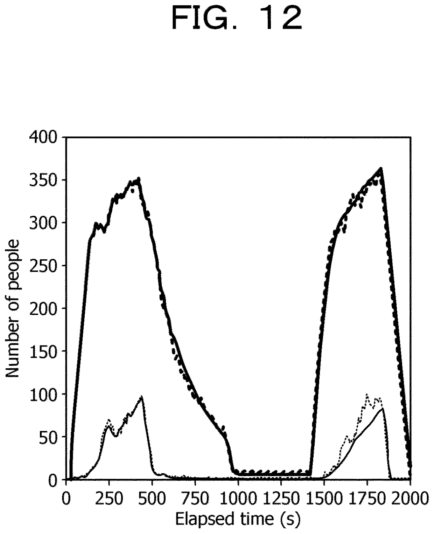

FIG. 11 is a diagram illustrating an example of a prediction result in the related art. FIG. 12 is a diagram illustrating an example of a prediction result in Embodiment 1. A vertical axis of each of graphs illustrated in FIGs. 11 and 12 indicates the number of persons, and a horizontal axis indicates a time of a simulation. In FIGs. 11 and 12, the number of persons around the exit 1 is plotted by a thick line, and the number of persons around the exit 2 is plotted by a thin line. In FIG. 11, the number of persons around the exit 1 and the number of persons around the exit 2 corresponding to the prediction result in the related art are plotted by solid lines, and the number of persons around the exit 1 and the number of persons around the exit 2 corresponding to the correct answer data are plotted by broken lines.

According to FIGs. 11 and 12, it is apparent that a simulation based on the parameter $\theta_1$ and the parameter $\theta_2$ of a discrete selection model estimated by data assimilation in the present embodiment may follow correct answer data, as compared with a simulation based on the parameter $\Theta$ estimated by data assimilation in the related art.

For example, as illustrated in FIG. 11, in the related art described above, there is a section in which the prediction result of the number of persons around the exit 1 may not follow the correct answer data due to the first wave congestion, and the prediction results of both the number of persons around the exit 1 and the number of persons around the exit 2 deviate from the correct answer data due to the second wave congestion. On the other hand, as illustrated in FIG. 12, in the present embodiment, it is understood that the prediction results of both the number of persons around the exit 1 and the number of persons around the exit 2 may follow the correct answer data in both the first wave and the second wave.

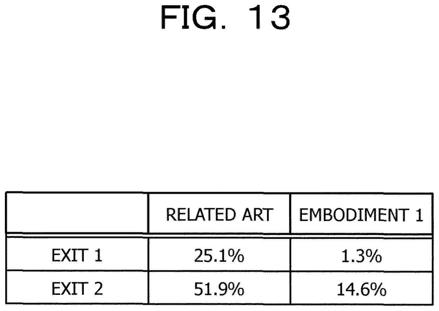

FIG. 13 is a diagram illustrating an aspect of a prediction error. FIG. 13 illustrates a prediction error of a congestion peak at each exit of the second wave of the people flow illustrated in FIGs. 11 and 12. As illustrated in FIG. 13, the prediction errors in the present embodiment are smaller than the prediction errors in the related art for both the congestion peak at the exit 1 of the second wave and the congestion peak at the exit 2 of the second wave. For example, the prediction error of the congestion peak at the exit 1 of the second wave may be reduced to approximately 1/20 of the prediction error in the related art, and the prediction error of the congestion peak at the exit 2 of the second wave may be reduced to approximately 1/3 or less of the prediction error in the related art.

<Flow of Process>

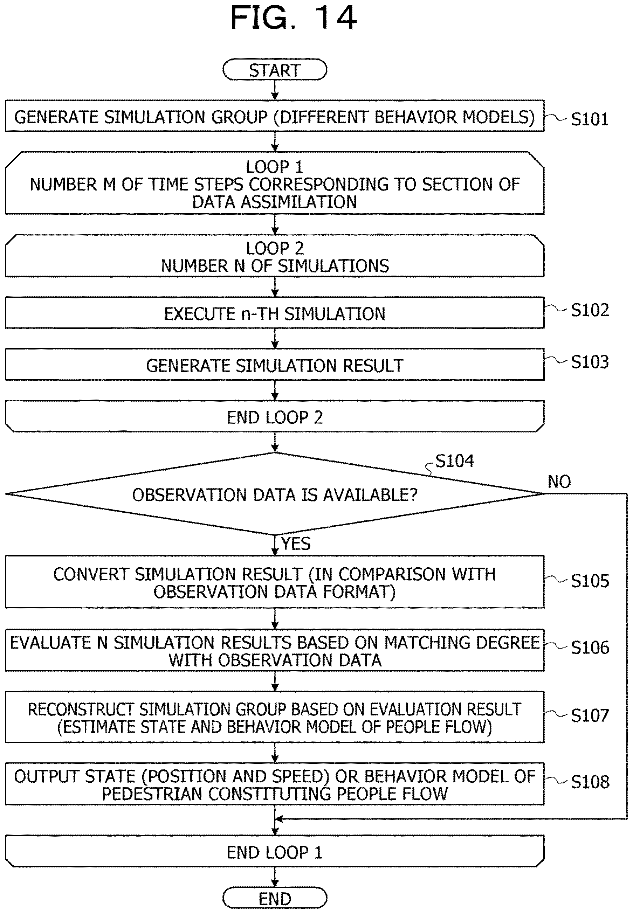

FIG. 14 is a flowchart illustrating a procedure of a data assimilation process. By way of example only, this process may be started in a case where a request to start data assimilation is received or at arbitrary timing at which observation data may be acquired.

As illustrated in FIG. 14, the execution unit 17A generates a simulation group by executing a plurality of ABS models in parallel at a start of data assimilation (step S101). A different behavior model is incorporated into each particle included in such a simulation group.

After that, the data assimilation unit 17 executes a loop process 1 of repeating processes from the following step S102 to the following step S108, for the number M of time steps corresponding to a section of the data assimilation.

The execution unit 17A of the data assimilation unit 17 executes a loop process 2 of repeating the processes of the following step S101 and the following step S107, for the number N of particles corresponding to the simulation group generated in the step S102 or the simulation group reconstructed in the following step S103.

Here, although an example in which the process of step S102 described below and the process of step S103 described below are repeated is described, the process of step S102 described below and the process of step S103 described below may be executed in parallel for each N particles.

For example, the execution unit 17A executes a simulation at the time t for the n-th particle to generate a simulation result (step S102 and step S103).

By repeating the loop process 2, the simulation result at the time t is obtained for each of N particles.

After that, in a case where observation data is available (Yes in step S104), the estimation unit 17B converts the simulation result of each particle into the same format as a format of the observation data (step S105).

After that, the estimation unit 17B evaluates the simulation result of each particle based on a matching degree between the simulation results of the N particles and the observation data (step S106).

Based on the result of evaluating the simulation result obtained in step S106, the estimation unit 17B estimates a behavior model that reproduces the observation data, and reconstructs the simulation group based on the behavior model obtained as the estimation result (step S107).

After that, the estimation unit 17B outputs the reconstructed simulation group and a state of an agent, for example, a position or a speed to the execution unit 17A (step S108).

After the process in step S108 is executed in this manner, the time t of the simulation is incremented by the time step $\Delta t$ until the data assimilation section ends, and the processes from step S102 to step S108 are repeated.

By such a loop process 1, a behavior model capable of reproducing the observation data acquired in the data assimilation section is estimated.

<For Digital Twin>

In the prediction function according to the present embodiment, a digital twin that reproduces observation data may be constructed, and a people flow may be predicted based on the constructed digital twin.

First, the measurement unit 16 generates observation data on a people flow by analyzing an image of an area in which structures corresponding to a plurality of options are disposed, the image being captured by a camera. Next, the data assimilation unit 17 executes a data assimilation process by incorporating the generated observation data related to the people flow into a simulation, and constructs a digital twin that predicts the people flow in the area based on the executed data assimilation process. For example, the data assimilation unit 17 constructs a digital twin that determines a behavior of an agent. For example, the data assimilation unit 17 estimates a behavior model that reproduces the observation data among behavior models that determine the behavior of the agent, and constructs a digital twin based on the estimated behavior model. Based on the constructed digital twin, the prediction unit 18 predicts the people flow in the area.

<One Aspect of Effects>

As described above, the server apparatus 10 according to the present embodiment estimates a behavior model that reproduces observation data by data assimilation, and predicts a people flow based on a simulation including the estimated behavior model. Therefore, even when a tendency of a behavior of a crowd is changed after the simulation is matched with the observation data by the data assimilation, it is possible to cause the simulation to follow the actual behavior. Therefore, with the server apparatus 10 according to the present embodiment, it is possible to follow the simulation up to a lead time desired to execute an intervention.

<Embodiment 2>

Although the embodiment related to the apparatus of the disclosure has been described hitherto, the present disclosure may be executed in various different forms other than the embodiment described above. Another embodiment of the present disclosure will be described below.

<Behavior Model>

Although an example of a plurality of discrete selection models to which different parameter sets are assigned is described as an example of the behavior model in Embodiment 1 described above, a type of the behavior model is not necessarily limited to the discrete selection model.

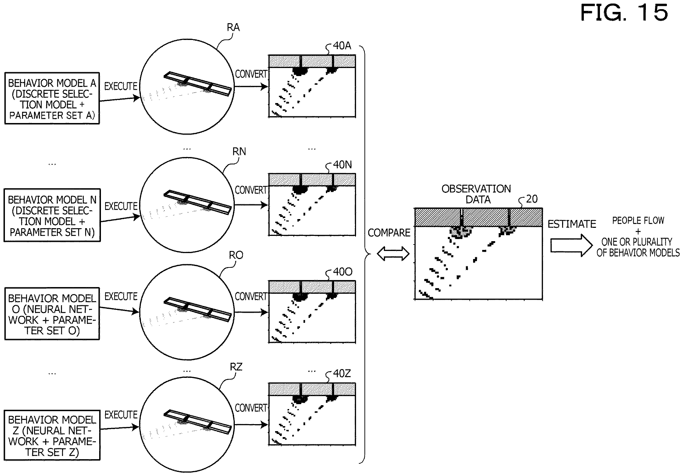

FIG. 15 is a schematic diagram illustrating an application example of data assimilation. FIG. 15 illustrates simulation results RA to RZ corresponding to Z particles, respectively. As illustrated in FIG. 15, the simulation results RA to RN are execution results of a simulation into which the behavior models A to N obtained by assigning the different parameter sets A to N to the parameters $\theta_1$ and $\theta_2$ of a discrete selection model are incorporated. The simulation results RO to RZ are execution results of a simulation in which behavior models O to Z obtained by assigning different parameter sets O to Z are incorporated into a neural network model that outputs a class label corresponding to an option of a behavior by using a feature amount as an input. Also for these simulation results RA to RZ, format conversion, calculation of a matching degree, and estimation of a behavior model may be executed in the same manner as in the example illustrated in FIG. 9. Although the neural network model is described as an example in FIG. 15, another machine learning model such as a support vector machine or gradient boosting, for example, may be used.

In this manner, a plurality of behavior models to which different parameters are assigned for each of the plurality of types of models may be incorporated into the simulation group. Although the behavior model having the parameter is illustrated as an example in FIGs. 9 and 15, a model having no parameter, for example, What-if scenario analysis or the like may be included in the behavior model incorporated into a generated simulation as a particle.

<Distribution and Integration>

Each of the components of each illustrated apparatus is not necessarily physically configured as illustrated. For example, specific forms of distribution and integration in each apparatus are not limited to those illustrated in the drawings. The entirety or part of the apparatus may be configured by being functionally or physically distributed or integrated in arbitrary units in accordance with various loads, usage situations, and the like. For example, the measurement unit 16, the data assimilation unit 17, or the prediction unit 18 may be coupled via a network as an external apparatus of the server apparatus 10. Another apparatus may include the measurement unit 16, the data assimilation unit 17, or the prediction unit 18 and may be coupled to the server apparatus 10 via the network and collaborate with the server apparatus 10 to enable the functions of the server apparatus 10.

<Hardware Configuration>

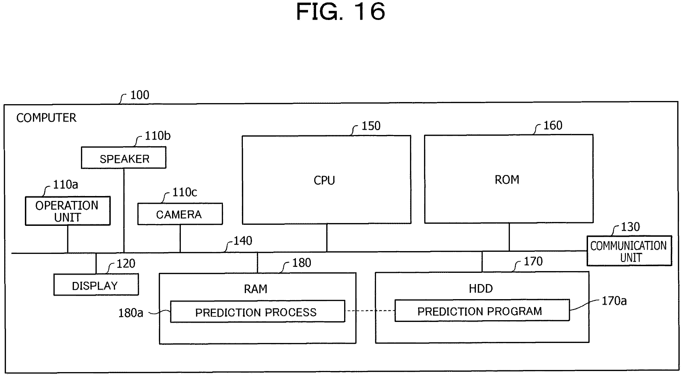

The various processes described in the above embodiments may be realized when a program prepared in advance is executed by a computer such as a personal computer or a workstation. An example of the computer that executes a prediction program having a function in the same manner as Embodiments 1 and 2 will be described below with reference to FIG. 16.

FIG. 16 is a diagram illustrating a hardware configuration example. As illustrated in FIG. 16, a computer 100 includes an operation unit 110a, a speaker 110b, a camera 110c, a display 120, and a communication unit 130. The computer 100 also includes a central processing unit (CPU) 150, a read-only memory (ROM) 160, a hard disk drive (HDD) 170, and a random-access memory (RAM) 180. These respective components 110 to 180 are coupled to each other via a bus 140.

As illustrated in FIG. 16, the HDD 170 stores a prediction program 170a that exhibits a function in the same manner as the measurement unit 16, the data assimilation unit 17, and the prediction unit 18 described in Embodiment 1 described above. In the same manner as the respective components of the measurement unit 16, the data assimilation unit 17, and the prediction unit 18 illustrated in FIG. 5, the prediction program 170a may be integrated or separated. For example, not all the pieces of data described in Embodiment 1 described above are necessarily stored in the HDD 170, and the HDD 170 may store the data used for the process.

Under such an environment, the CPU 150 reads the prediction program 170a from the HDD 170, and loads the prediction program 170a onto the RAM 180. As a result, the prediction program 170a functions as a prediction process 180a, as illustrated in FIG. 16. The prediction process 180a loads various types of data read from the HDD 170 in a region allocated to the prediction process 180a in a storage region included in the RAM 180, and executes various processes by using the loaded various types of data. For example, the process executed by the prediction process 180a may include the process illustrated in FIG. 14 and the like as an example. Not all the processing units described in Embodiment 1 above necessarily operate in the CPU 150. It is sufficient that a processing unit corresponding to the processing to be executed be virtually realized.

The prediction program 170a described above is not necessarily initially stored in the HDD 170 or the ROM 160. For example, the prediction program 170a is stored in a "portable physical medium" such as a flexible disk called an FD, a compact disk (CD)-ROM, a Digital Versatile Disk (DVD), a magnetooptical disk, or an integrated circuit (IC) card to be inserted into the computer 100. The computer 100 may acquire the prediction program 170a from the portable physical medium, and execute the acquired prediction program 170a. The prediction program 170a is stored in another computer, another server apparatus, or the like coupled to the computer 100 via a public network, the Internet, a local area network (LAN), a wide area network (WAN), or the like. The prediction program 170a stored in this manner may be downloaded to the computer 100 and then executed.

The following appendices are further disclosed in relation to the embodiment including the exemplary embodiment described above.

**Claims**

1. A prediction program for causing a computer to execute a process comprising:

   measuring a feature amount related to a plurality of options and a people flow to be reproduced based on the plurality of options;
   executing a simulation of the people flow by using the measured feature amount;
   specifying a model that determines a behavior of the people flow in accordance with an input of the measured feature amount, based on the executed simulation of the people flow and the measured people flow; and
   predicting the people flow based on the specified model.

2. The prediction according to claim 1, wherein

   the executing includes executing a simulation group of the people flow into which each of a plurality of first models which are the same type of models and to which different parameter sets are assigned is incorporated, and
   the specifying includes specifying, in the simulation group of the people flow, a first model incorporated into a simulation of the people flow in which a matching degree with the measured people flow satisfies a specific condition.

3. The prediction according to claim 1, wherein

   the executing includes executing a simulation group of the people flow into which each of a plurality of first models which are a first type of models and to which different parameter sets are assigned and a plurality of second models which are a second type of models different from the first type and to which different parameter sets are assigned is incorporated, and
   the specifying includes specifying, in the simulation group of the people flow, a first model or a second model or any combination thereof incorporated into a simulation of the people flow in which a matching degree with the measured people flow satisfies a specific condition.

4. The prediction according to claim 1, wherein

   in the executing, a simulation group of the people flow into which each of a plurality of first models which are a first type of models and to which different parameter sets are assigned and a second model with a type different from the first type is incorporated is executed, and

the specifying includes specifying, in the simulation group of the people flow, a first model or a second model or any combination thereof incorporated into a simulation of the people flow in which a matching degree with the measured people flow satisfies a specific condition.

5. The prediction according to claim 1, wherein

the model corresponds to a discrete selection model, and
in the specifying, the discrete selection model is specified by comparing the executed simulation of the people flow with the measured people flow.

6. The prediction according to claim 1, wherein

in the measuring, observation data related to the people flow is generated by analyzing an image, which is captured by a camera, of an area in which structures that correspond to the plurality of options are disposed,
in the specifying, a data assimilation process is executed by incorporating the generated observation data related to the people flow into the simulation, and a digital twin that predicts the people flow in the area is constructed based on the executed data assimilation process, and
in the predicting, the people flow in the area is predicted based on the digital twin.

7. The prediction according to claim 1, wherein

the plurality of options are gates that indicate any one of an entrance for a person to enter a predetermined location or an exit for the person to exit from the predetermined location,
the feature amount is a distance to the gate or a congestion degree of the gate, and
the simulation of the people flow is an agent-based simulation.

8. A prediction method implemented by a computer, the prediction method comprising:

measuring a feature amount related to a plurality of options and a people flow to be reproduced based on the plurality of options;
executing a simulation of the people flow by using the measured feature amount;
specifying a model that determines a behavior of the people flow in accordance with an input of the measured feature amount, based on the executed simulation of the people flow and the measured people flow; and
predicting the people flow based on the specified model.

9. An information processing apparatus comprising:
a processer configured to:

measure a feature amount related to a plurality of options and a people flow to be reproduced based on the plurality of options;
execute a simulation of the people flow by using the measured feature amount;
specify a model that determines a behavior of the people flow in accordance with an input of the measured feature amount, based on the executed simulation of the people flow and the measured people flow; and
predict the people flow based on the specified model.

# FIG. 1

30A
OBSERVATION DEVICE

30B
OBSERVATION DEVICE

⋮

30N
OBSERVATION DEVICE

NW

1

10
SERVER APPARATUS

50
CLIENT TERMINAL

# FIG. 2

EXIT 1          EXIT 2

CLOSE EXIT WHEN
BEING VACANT

DISTANT EXIT WHEN
BEING CROWDED

# FIG. 3

EXIT 1      EXIT 2

RELATED ART
ESTIMATE THAT RATIO BETWEEN EXIT 1 AND EXIT 2
IS APPROXIMATELY 7:3
=> WHEN EXIT 1 IS VACANT, RATIO IS 10:0, AND
PREDICTION BASED ON 7:3 DEVIATES

# FIG. 4

EXIT 1          EXIT 2

EMBODIMENT 1
ESTIMATE LOGIC OR PARAMETER OF MODEL FOR
DETERMINATION MAKING INDICATING HOW MANY
PERSONS SELECT TO GO TO EXIT 2 WHEN CONGESTION
DEGREE OF EXIT 1 HAS THIS DEGREE
=> ESTIMATE WITH HIGH ACCURACY EVEN WHEN EXIT
1 IS VACANT

# FIG. 5

# FIG. 6

EXIT 1

EXIT 2

# FIG. 7

# FIG. 8

FIG. 9

RA

EXECUTE

BEHAVIOR MODEL A
(DISCRETE SELECTION
MODEL + PARAMETER
SET A)

CONVERT

40A

RB

EXECUTE

BEHAVIOR MODEL B
(DISCRETE SELECTION
MODEL + PARAMETER
SET B)

CONVERT

40B

RN

EXECUTE

BEHAVIOR MODEL N
(DISCRETE SELECTION
MODEL + PARAMETER
SET N)

CONVERT

40N

COMPARE

OBSERVATION
DATA          20

ESTIMATE

PEOPLE FLOW
+
ONE OR PLURALITY OF
BEHAVIOR MODELS

# FIG. 10

# FIG. 11

# FIG. 12

# FIG. 13

|  | RELATED ART | EMBODIMENT 1 |
|---|---|---|
| EXIT 1 | 25.1% | 1.3% |
| EXIT 2 | 51.9% | 14.6% |

# FIG. 14

```
                           ( START )
                              │
                              ▼
┌──────────────────────────────────────────────────────────┐
│ GENERATE SIMULATION GROUP (DIFFERENT BEHAVIOR MODELS) │∿ S101
└──────────────────────────────────────────────────────────┘
                              │
                              ▼
┌──────────────────────────────────────────────────────────┐
│                        LOOP 1                            │
│  NUMBER M OF TIME STEPS CORRESPONDING TO SECTION OF      │
│                   DATA ASSIMILATION                      │
└──────────────────────────────────────────────────────────┘
                              │
                              ▼
┌──────────────────────────────────────────────────────────┐
│                        LOOP 2                            │
│                 NUMBER N OF SIMULATIONS                   │
└──────────────────────────────────────────────────────────┘
                              │
                              ▼
┌──────────────────────────────────────────────────────────┐
│              EXECUTE n-TH SIMULATION                     │∿ S102
└──────────────────────────────────────────────────────────┘
                              │
                              ▼
┌──────────────────────────────────────────────────────────┐
│             GENERATE SIMULATION RESULT                   │∿ S103
└──────────────────────────────────────────────────────────┘
                              │
                              ▼
┌──────────────────────────────────────────────────────────┐
│                      END LOOP 2                          │
└──────────────────────────────────────────────────────────┘
                              │
                              ▼                    S104
                      ◇ OBSERVATION DATA IS AVAILABLE? ◇ ──── NO ──┐
                              │                                    │
                              │ YES                                │
                              ▼                                    │
┌──────────────────────────────────────────────────────────┐      │
│   CONVERT SIMULATION RESULT (IN COMPARISON WITH          │∿ S105 │
│              OBSERVATION DATA FORMAT)                     │      │
└──────────────────────────────────────────────────────────┘      │
                              │                                    │
                              ▼                                    │
┌──────────────────────────────────────────────────────────┐      │
│ EVALUATE N SIMULATION RESULTS BASED ON MATCHING DEGREE   │∿ S106 │
│               WITH OBSERVATION DATA                      │      │
└──────────────────────────────────────────────────────────┘      │
                              │                                    │
                              ▼                                    │
┌──────────────────────────────────────────────────────────┐      │
│ RECONSTRUCT SIMULATION GROUP BASED ON EVALUATION RESULT  │∿ S107 │
│  (ESTIMATE STATE AND BEHAVIOR MODEL OF PEOPLE FLOW)      │      │
└──────────────────────────────────────────────────────────┘      │
                              │                                    │
                              ▼                                    │
┌──────────────────────────────────────────────────────────┐      │
│ OUTPUT STATE (POSITION AND SPEED) OR BEHAVIOR MODEL OF   │∿ S108 │
│     PEDESTRIAN CONSTITUTING PEOPLE FLOW                  │      │
└──────────────────────────────────────────────────────────┘      │
                              │◄───────────────────────────────────┘
                              ▼
┌──────────────────────────────────────────────────────────┐
│                      END LOOP 1                          │
└──────────────────────────────────────────────────────────┘
                              │
                              ▼
                           (  END  )
```

FIG. 15

# FIG. 16

COMPUTER ~ 100

SPEAKER ~ 110b

OPERATION UNIT ~ 110a

CAMERA ~ 110c

CPU ~ 150

ROM ~ 160

COMMUNICATION UNIT ~ 130

DISPLAY ~ 120

RAM ~ 180
PREDICTION PROCESS ~ 180a

HDD ~ 170
PREDICTION PROGRAM ~ 170a

~ 140

Europäisches
Patentamt

European
Patent Office

Office européen
des brevets

# EUROPEAN SEARCH REPORT

Application Number

EP 24 19 5842

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2023/195964 A1 (MAKINOSHIMA FUMIYASU [JP] ET AL) 22 June 2023 (2023-06-22) * paragraphs [0023] - [0076]; figures 1,8 * | 1-9 | INV. G06Q10/04 G06Q50/26 |
| A | CLAY ROBERT ET AL: "Real-time agent-based crowd simulation with the Reversible Jump Unscented Kalman Filter", SIMULATION MODELLING PRACTICE AND THEORY, ELSEVIER, AMSTERDAM, NL, vol. 113, 8 August 2021 (2021-08-08), XP086774861, ISSN: 1569-190X, DOI: 10.1016/J.SIMPAT.2021.102386 [retrieved on 2021-08-08] * page 10 * | 7 | |
| A | US 2020/082306 A1 (YAMADA HIROAKI [JP] ET AL) 12 March 2020 (2020-03-12) * paragraphs [0024], [0075] - [0077] * | 7 | |
| A | HU YITING ET AL: "Passenger Congestion Alleviation in Large Hub Airport Ground Access System Based on Queueing Theory", ARXIV.ORG, CORNELL UNIVERSITY LIBRARY, 201 OLIN LIBRARY CORNELL UNIVERSITY ITHACA, NY 14853, 19 September 2022 (2022-09-19), XP091320257, DOI: 10.1080/21680566.2022.2062481 * page 2 * | 5 | TECHNICAL FIELDS SEARCHED (IPC) G06Q G06V |

-/--

The present search report has been drawn up for all claims

| Place of search | Date of completion of the search | Examiner |
|---|---|---|
| Munich | 9 December 2024 | Hopper, Eva |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

**Application Number**

EP 24 19 5842

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CENTORRINO P ET AL: "Managing crowded museums: Visitors flow measurement, analysis, modeling, and optimization", JOURNAL OF COMPUTATIONAL SCIENCE, ELSEVIER, AMSTERDAM, NL, vol. 53, 3 April 2021 (2021-04-03), XP086692900, ISSN: 1877-7503, DOI: 10.1016/J.JOCS.2021.101357 [retrieved on 2021-04-03] * page 2 * | 6 | |
| | ----- | | |
| | | | **TECHNICAL FIELDS SEARCHED (IPC)** |

The present search report has been drawn up for all claims

| Place of search | Date of completion of the search | Examiner |
|---|---|---|
| Munich | 9 December 2024 | Hopper, Eva |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

\.....................................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 19 5842

This annex lists the patent family members relating to the patent documents cited in the above-mentioned European search report.
The members are as contained in the European Patent Office EDP file on
The European Patent Office is in no way liable for these particulars which are merely given for the purpose of information.

09-12-2024

| Patent document cited in search report | | Publication date | Patent family member(s) | | Publication date |
|---|---|---|---|---|---|
| US 2023195964 | A1 | 22-06-2023 | EP | 4198849 A1 | 21-06-2023 |
| | | | JP | 2023090405 A | 29-06-2023 |
| | | | US | 2023195964 A1 | 22-06-2023 |
| US 2020082306 | A1 | 12-03-2020 | JP | 7105227 B2 | 22-07-2022 |
| | | | JP | WO2018211599 A1 | 26-12-2019 |
| | | | US | 2020082306 A1 | 12-03-2020 |
| | | | WO | 2018211599 A1 | 22-11-2018 |

EPO FORM P0459

For more details about this annex : see Official Journal of the European Patent Office, No. 12/82

**REFERENCES CITED IN THE DESCRIPTION**

**Patent documents cited in the description**

- JP 2023090405 A